# EUROPEAN PATENT SPECIFICATION

(11) **EP 3 182 206 B1**
(45) Date of publication and mention of the grant of the patent: **04.12.2019**
(21) Application number: 15200040.2
(22) Date of filing: 15.12.2015
(51) Int. Cl.: G03F 7/20

(54) **A METHOD OF EXPOSING A PRINT MASTER PRECURSOR**
VERFAHREN ZUM BELICHTEN EINES DRUCKMASTERPLATTENROHLINGS
MÉTHODE D'EXPOSITION D'UNE PLAQUE D'IMPRESSION

(43) Date of publication of application: 21.06.2017
(60) Divisional application: 19200344.0
(73) Proprietor: AGFA NV, 2640 Mortsel (BE)
(72) Inventor: Van Dorpe, Jurgen, 2640 Mortsel (BE); Meuris, Werner, 2640 Mortsel (BE)

(56) References cited:
- GB-A- 2 217 862
- US-A1- 2003 214 611
- HAYASHI T ET AL: "Photolithography system with liquid crystal display as active gray-tone mask for 3D structuring of photoresist", SENSORS AND ACTUATORS A, ELSEVIER SEQUOIA S.A., LAUSANNE, CH, vol. 144, no. 2, 15 June 2008 (2008-06-15) , pages 381-388, XP022664319, ISSN: 0924-4247, DOI: 10.1016/J.SNA.2008.02.014 [retrieved on 2008-03-07]

## Description

### Technical Field

The invention relates to a method for exposing a print master precursor such as a relief print master precursor using a digital mask panel.

### Background Art

### flexographic printing

In flexographic printing a flexible cylindrical relief print master is used for transferring a fast drying ink from an anilox roller to a printable substrate. The print master can be a flexible plate that is mounted on a cylinder or it can be a cylindrical sleeve.

Because the flexographic print master has elastic properties, the process is particularly suitable for printing on a wide range of printable substrates including for example corrugated fiberboard, plastic films or even metal sheets.

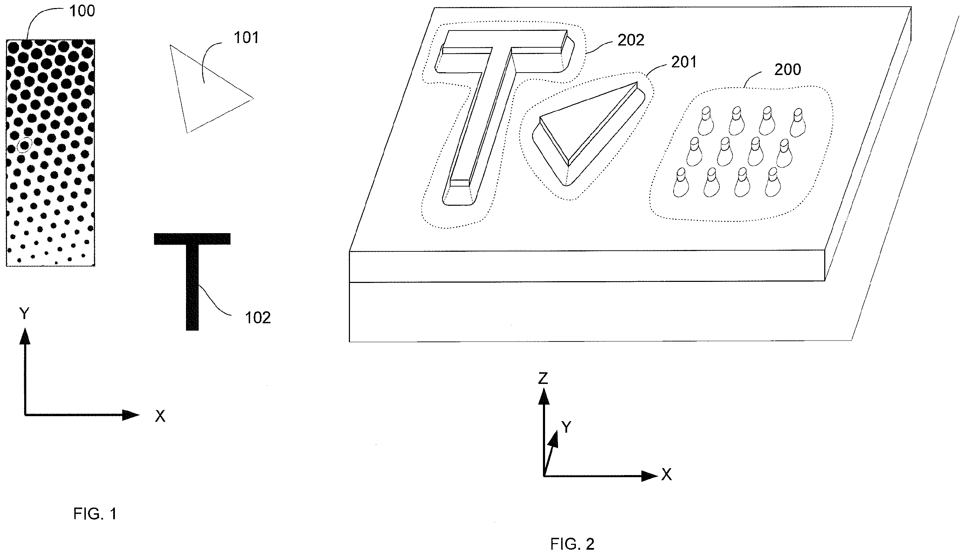

The raised portions (200, 201, 202) of the relief print master in FIG. 2 define the image features (100, 101, 102) in FIG. 1 that are to be printed.

Examples of a flexographic print master precursor are found in the range of Cyrel® EASY plate systems, manufactured and marketed by the company DuPont™.

A range of equipment that was designed to expose these Cyrel® plates is manufactured and marketed by the company Esko and is called the "CDI Spark" series ("CDI" stands for "Cyrel Digital Imager").

The negative film through which a print master precursor is exposed can be obtained in different ways.

A first method is to expose a photographic film by means of a CtF ("Computer to Film") exposing unit in response to a printable digital file that is delivered by a RIP (Raster Image Processor). After development in a hydroquinone- and metol-based developer and fixation in an acidic solution, a suitable film is obtained.

An alternative technique uses LAM (Laser Ablation Mask) as a dry patterning process in which a high energy beam of light from an excimer laser is used to directly pattern a suitable material and to obtain a mask. An advantage of this method is that no additional development and fixing step are required.

A traditional method for making a flexographic print master starts from negative film that defines the image features and that is laid upon a sheet of photopolymerizable material. The sheet is exposed by means of a UV light source through the negative film which acts like a mask.

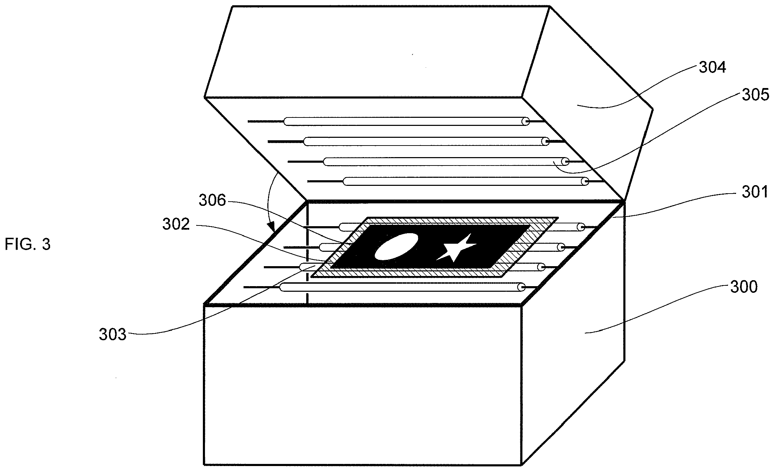

FIG. 3 shows a light box (300) that can be used for the purpose of creating a flexographic print master. A flexographic print master precursor 302 rests on a transparent plate in a frame (301). Below the frame resides a first UV light source comprising fluorescent light bulbs (303). In a lid (304) that is connected with hinges to the light box resides a second UV light source comprising fluorescent light bulbs (305). On top of the flexographic print master precursor lies a negative film (306) with the image features.

The operation is as follows. During an exposure the lid 304 is always closed.

In a first step ("back exposure") the back of the printing plate precursor (302) is exposed by the UV-A light source 303. The effect of this exposure is that the photopolymerization in the printing plate precursor is initiated. This reduces the threshold for further polymerization during subsequent exposure steps and hence raises the photosensitivity of the precursor.

In a second step ("main exposure") the plate precursor 302 is exposed through the negative film mask (306) by the UV-A light source (305) in the lid 304. The effect of this is that the portions of the polymerizable sheet underneath the transparent parts of the film selectively polymerize under influence of the UV-A light, whereas the portions under the opaque parts of the film remain soluble. This generates the latent relief image required for the printing process.

A third step ("wash-out") includes washing out the non polymerized monomer by means of a brush and a wash-out solution. The wash-out is followed by a "drying step" so that the wash-out solution that was absorbed by the precursor can evaporate.

A fourth step ("finishing step" or "detacking step") consists of curing the surface of the precursor by means of a short time exposure with a UV-C light source. This stabilizes the physical and chemical properties of the surface of the precursor.

A fifth and a last step ("final exposure") includes curing the precursor with UV-A light source. This final exposure ensures that all remaining monomers in the precursor are crosslinked. It also determines the final physical characteristics such as hardness of the resulting flexographic print master.

### three-dimensional printing for making a relief print master

A three-dimensional printing technique for forming a flexographic print master is disclosed in EP 1428666 B (AGFA GRAPHICS NV) 11/12/2002. According to this method an inkjet printing system is used for jetting on a substrate at least two image-wise layers of a polymerizable fluid. After a first layer has been jetted, it is immobilized ("cured") before the subsequent layer is applied. The immobilisation is achieved with UV-light. Because according to this method the flexographic printing master is build up layer by layer, it is at least theoretically possible to control the slope of the image features in a different way for positive or for negative image features using image processing. Small positive features could receive a soft slope, whereas small negative features on the contrary could receive a steep slope. One of the problems with the above method, however, is that it is difficult to control the exact shape and thickness of the layers that are formed by jetting UV-curable ink droplets with a print head. This is related to a variety of factors such as surface tension effects and the round (as opposed to "cubic") shape of the droplets when they land onto the printable surface. These effects tend to accumulate layer by layer and the result is that the top layer of the image features does not lie in a perfect plane as would be ideal for a flexographic print master. Having not all the top layers in the same plane causes uneven pressure between the print master and the printable substrate on the rotary press, resulting in uneven transfer of the ink and serious degradation of the quality of the printed image.

Another method is disclosed in EP 2199066 B (AGFA GRAPHICS NV) 19/12/2008. According to this publication multiple layers of a flexographic print master on a drum are simultaneously created during a single cycle by different nozzles of the same print head. The advantage over the previous method is that the result is a print sleeve that is directly suitable for mounting on a rotary printing press and that print masters can be created that are 360° seamless. However, given that the print master is build up using a similar additive process of jetting UV-curable ink droplets to form additive layers as in the previous publication, the method suffers from the same deficiency that the top layers doe not lie in a perfect cylindrical plane.

### digital exposure systems

US 5049901 B (CREO PRODUCTS INC) 2/07/1990 introduces the use of a two-dimensional array of digital micro-mirrors for the purpose of exposing a print plate precursor. An imaging unit comprises a light source such as an arc lamp and a collimation lens in combination with a two-dimensional array of digital micro-mirrors and a projection lens. The imaging unit moves in a linear fashion relative to a light-sensitive printing plate precursor and exposes its surface in response to the pixels of a binary bitmap that defines the image that is to be printed by the print plate. According to the invention, each location on the recording surface is exposed multiple times by distinct rows of the digital micro-mirror device while the latter scans the surface. The invention reduces the requirements for the power of the light source by taking advantage of the relatively large area of the two-dimensional digital micro-mirror device compared to the case when only a single row of micro mirrors would be used.

EP 0950212 B (FRIEDRICH LÜLLAU) 31/12/1996 teaches that before exposing a light-sensitive surface, a binary bitmap is first broken down along the two dimensions into a set of contiguous rectangular partial bitmaps. A partial bitmap is exposed onto a light-sensitive printing plate precursor using an imaging unit that comprises a light source and a collimation lens in combination with a two dimensional light modulator such as an LCD panel, and a projection lens. The complete image is reconstructed by moving the imaging unit stepwise over the light-sensitive surface and each time exposing the corresponding partial bitmap.

GB 2 217 862 A relate to a method of exposing print master precursor using a digital mask panel.

### liquid crystal displays

High resolution and large format liquid crystal displays are currently available for application in video displays. For example a 60" video RGB display with a 16/9 aspect ratio is commercially available that has 3996×2160 (4K resolution TV) addressable pixels and that features a frame-update frequency of 60 frames per second. The size of such a panel is approximately approximately 130 cm by 70 cm and a single RGB pixel has a size of approximately 325 µm by 325 µm.

Given that every RGB pixel actually comprises three subpixels, the dimensions of a subpixel are rather 325 µm by 108 µm.
Further background art is found in an article "Photolithography system with liquid crystal display as active gray-tone mask for 3D structuring of photoresist" by Terutake Hayashi , Takayuki Shibata, Takahiro Kawashima, Eiji Makino, Takashi Mineta, Toru Masuzawa, published in "Sensors and Actuators A", Physical Volume 144, Issue 2, 15 June 2008, Pages 381-388, ISSN 0924-4247, edited by Elsevier wherein a small digital mask panel is used for the development of micro electromechanical systems and micro total analysis systems by selective exposure through relay lens optical system and mirror on an exposure plane.

### Unresolved problems

The current technology to create a flexographic print master is still insufficient. The need to prepare a contact film in the traditional plate making process is a step that requires separate equipment and that involves additional production steps. The three-dimensional printing methods for making a relief print master solve these problems but require equipment that is complex and expensive.

### Summary of invention

The invention is disclosed in the independent claim 1 and the dependent claims.

The current invention deals with an improved system for creating a flexographic or offset print master that uses a two-dimensional transparent light valve array that is driven by a raster image processor. The array provides the equivalent of a digital contact mask, thereby eliminating the need for additional equipment to create a contact film. Since the contact mask is essentially solid-state, it is significantly less complex and expensive than systems for creating a relief print master using three-dimensional printing.

### Brief description of drawings

FIG. 1 shows a set of different image features;
FIG. 2 shows a relief print master for printing the different image features in FIG. 1;
FIG. 3 shows a light box suitable for making a relief print master;
FIG. 4 shows an exploded view of a digital master according to the current invention;
FIG. 5 shows an equivalent electrical circuit for driving the elements of a digital mask according to the current invention;
FIG. 6A and 6B show two alternative embodiments for a lay out of a transistor with regard to the element that the transistor is driving.

### Description of embodiments

### the panel

The panel is a two-dimensional panel having pixels that can have two conditions of translucency. In a first condition, which is arbitrarily called an off-condition, the transparency is low and in a second condition the transparency is high.

### basic specifications of the panel for plate making

The dimensions of the panel are preferably selected so that it easily retrofits in existing light frames. The inventors have found that a panel size of 1250 mm by 950 mm covers 80% of the light frames that are currently used in the flexographic industry and therefore is a preferred size. According to the invention the panel has a width in the range from 850 mm to 1050 mm and a height in the range from 1150 mm to 1350 mm.

The inventors have found that for the purpose of plate making, the pixels are preferably square and their size is preferably 40 µm by 40 µm or less. If high quality halftone images are desired the pixel size is preferably 20 µm by 20 µm or less and even more preferably 10 µm by 10 µm or less.

Such small pixel sizes are within reach of the current state of the art, especially since the specifications for other technical characteristics of the invented panel can be relaxed compared to the specifications for video displays.

The inventors have found that for the purpose of plate-making, the ratio of the second over the first transparency level ("the contrast ratio") is preferably 20/1 or higher, preferably 100/1 or higher when measured in the UV-A spectrum (315 - 400 nm).

As far as tonal resolution is concerned, one bit monochrome tonal resolution is sufficient. Preferably the tonal resolution is 2 or even 3 bits.

The display refresh time (the time to reload a complete image) should be less than 20 seconds, preferably less than 5 seconds.

Whereas "viewing angle width" is an important characteristic in display panels, this is not at all the case for a panel in current invention. On the contrary even since a wide viewing angle promotes optical cross talk between neighboring pixels in the panel.

The lifetime of the panel is defined as the time span from new to the point in time when more than 1 out of 10.000 isolated pixels fail or when the contrast ratio of the panel gets below 20/1. A failing pixel is defined as a pixel that is permanently in the first or in the second translucency state.

During a single exposure the panel receives an amount of energy in the UV-A light spectrum (315 nm to 400 nm) equivalent to between 9 J/cm² and 18 J/cm². The panel is designed to resist this energy at least 10.000 times before an appreciable decay becomes apparent and before the contrast either locally or globally is reduced to a level of 20/1 or less.

### panel build-up

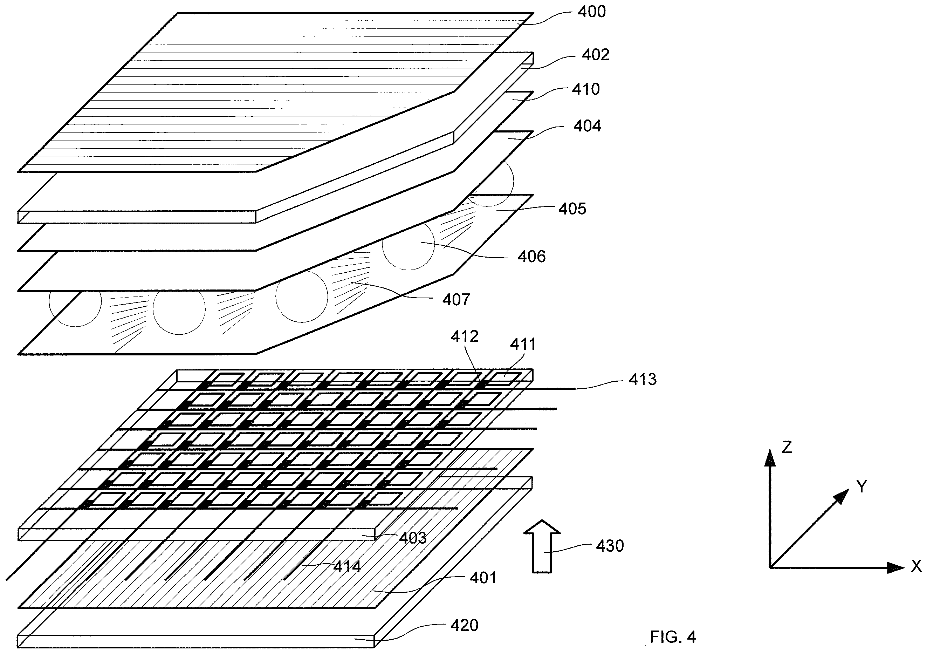

FIG. 4 shows an exploded view of an exemplary panel that is suitable for use in the current invention. Only the most essential elements are shown. The figure was not drawn at scale.

At the heart of the panel are "twisted nematic liquid crystals" (407). The optical characteristics of the molecules in such a twisted nematic liquid crystal are highly asymmetrical. They are organized around a path that is roughly parallel to the Z-dimension in a way that is similar to the steps of a helical staircase. As a result the twisted nematic liquid crystals behave like a circular optical polarizing filter. In this particular case the twisted nematic liquid crystals are designed to turn the optical polarization of light that passes parallel to the Z axis by ninety degrees.

The twisted nematic liquid crystals reside between two polymer layers (404 and 405) that are kept at a fixed distance by multiple spacer spheres (406). The diameter of the spacer spheres is in the order of microns, for example 4 µm, preferably between 2 µm and 4 µm.

The polymer layers (404 and 405) themselves are sandwiched in between two ultra-thin glass plates (402 and 403). The thickness of the plate 403 is around 0.8 mm, preferably between 0.5 mm en 1.5 mm. The thickness of the glass plate (403) is preferably below 0.05 mm, for example 0.03 mm.

In between the glass plate (402) and the polymer foil (404) is a transparent electrode (410) which is kept at a fixed electrical potential such as for example the ground potential.

In between the glass plate 403 and the polymer foil 405 resides a matrix of transparent electrodes (411) - one per pixel. The potential of every electrode (411) is controlled by means of a thin-film field effect transistor (412). The gate of the thin film field effect transistor (412) is driven by a gate line conductor (413) and the source by a data line conductor (414). The electrode (411) in combination with the electrode 410 forms a capacitor - one per pixel that keeps its charge during a complete cycle between two updates of the pixel value.

The optical polarizing filter (400) only passes light along the Z-dimension according to a first orientation in the X-Y plane, whereas the optical polarizing filter (401) only passes light along a second dimension in the X-Y plane that is orthogonal to the first dimension.

The element (420) is a collimating micro-lens system having the same pitch as the two-dimensional pixel array and being aligned to it.

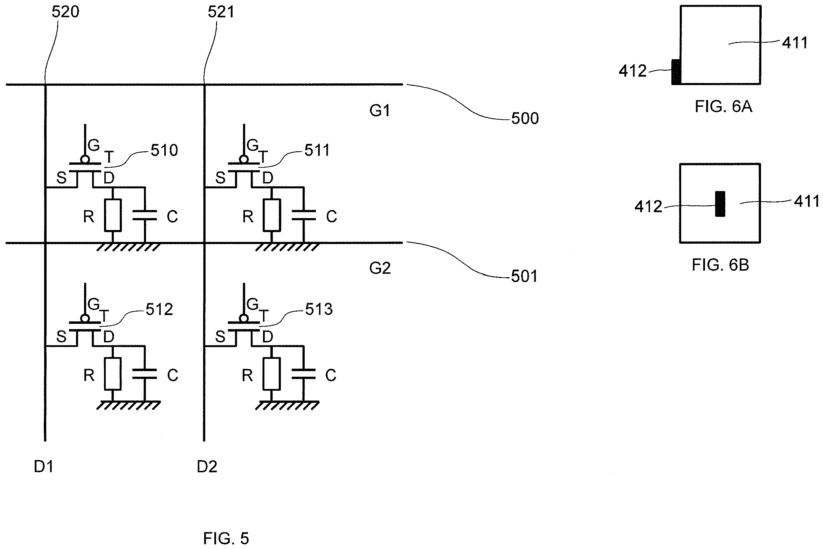

FIG. 5 shows the equivalent electric circuit of the electronics that drive a four individual pixels.

G1 and G2 are two conducts (500, 501) that are connected to the gates G of four field effect transistors T (510-513).

D1 and D2 are data lines (520, 521) to which the sources of the field effect transistors (510-513) are connected.

The drain D of every field effect transistor is connected to an electrode 411 having a capacity C with regard to the common electrode 410. The resistor R corresponds with the parallel electrical resistance that is caused by the twisted nematic liquid crystals and the field effect transistor.

### electrical operation of the panel

The field effect transistors in FIG. 5 act like on-off switches. When the gate line conductors G1 and G2 (500, 501) are electrically grounded, the transistors (510-513) behave like open switches. The capacities C corresponding to the pixels are essentially isolated in that case from the driving circuitry and the only discharge of these capacities C is caused by the leakage current flowing through the parallel resistors R. Therefore the voltage across the capacitors C and the electrical field between the electrodes of these capacitors remains essentially constant.

When a positive voltage is applied to one of the gate line conductors (500-501), for example to the gate line conductor 500, the transistors (510 and 511) of which the gates G are connected to the gate line conductor (500) will start conducting. In that case the capacitors C that are connected to the transistors (510-511) will be charged or discharged depending on the voltage on the data line conductors (520-521) to which the sources S of the transistors (510-511) are connected. In this way, all the capacitors C of the row of pixels that corresponds with the gate line conductor (500) can be charged or discharged to obtain a specific electrical field between the corresponding sets of their electrodes.

By repeating this process for the other rows of pixels, the electrical fields between the electrodes of all the capacitors corresponding to a pixel in the two-dimensional panel can be individually addressed.

In practice, all the gate line conductors are activated by a circular counter that addresses sequentially all the rows of pixels. For every row of pixels a multiplexer circuit selects the appropriate digital count values for every column pixel on the selected row. By means of a D/A-convertor the digital count value of every pixel on said row is converted in a corresponding voltage that is applied to the corresponding data line conductor.

### optical operation of the panel (FIG. 4)

The collimating micro-lens system (420) converts the diffuse incoming light into a parallel beam of light rays.

When a collimated light beam along the Z-dimension passes through the optical polarizing filter (401) in the direction of the arrow (430), only that portion of the light that corresponds with the orientation of the optical polarizing filter will get through.

When the electrical field across a capacity formed by two electrodes (410 and 411) corresponding to a pixel is zero, the filtered light next passes through the twisted nematic liquid crystals (407), where its optical polarization orientation will be turned by ninety degrees because of the circular optical polarization characteristic of the twisted nematic liquid crystals.

As a result the polarization orientation of the light when it has passed the twisted nematic liquid crystal, lines up with the orientation of the optical polarization filter (400). The net effect is that the light beam will pass through the pixel that corresponds with the electrode (411).

When the electrical field between the electrodes (410) and (411) of a pixel is not equal to zero, the molecules of the twisted nematic liquid crystal will line up along the lines of this electric field, effectively breaking up the optical circular polarization characteristic of the twisted nematic liquid crystal. As a result the polarization of only a portion of the light that passes along the Z-dimension through the twisted nematic crystals will be turned 90 degrees. The portion that has not been turned 90 degrees will be blocked by the optical polarizing filter (400), since the orientation of that portion does not line up with the orientation of said filter (400). The net effect is that not all the light will pass through the pixel.

With the just described mechanism it is possible to turn on and off the transparency of an individual pixel, by controlling the voltage of the gate and data line conductors (413 and 414).

The system is best described by the term "two-dimensional matrix of light valves".

### RIP, network and drivers

A raster image processor (RIP) converts a page that is described in a page description language such as "Portable Document Format" (PDF) into a raster bitmap such as for example a TIFF bitmap. The following table shows that for a panel having dimensions equal to 1250 mm by 950 mm in combination with a pixel size of 10 µm and 1 bits per pixel the TIFF image has a size of almost 1.5 GB.

| | |
|---|---|
| panel width | 1.25m |
| panel height | 0.95m |
| pixel size | 10E-06 m |
| nbr of bits p | 1 bits/pixel |
| nbr of bytes | 1. 484E+09 Bytes |

The bitmap can be temporarily stored in a computer memory (or on a hard disk) before it is sent to the panel. In order to transfer the bitmap in the example to the panel in a time less than 20 s, a transfer speed is needed of at least 75 MB/s. This transfer speed falls well within the limits of standard serial communication channels such as Ethernet.

On the panel itself resides a demultiplexer which unpacks the stream of incoming bytes into a two-dimensional matrix with digital count values for the pixels.

### variations

A number of variations exist regarding the panel geometry.

In a first variation, the electrical fields that control the polarization characteristic of the nematic liquid crystal are not oriented along the Z-dimension, but rather along the X or Y-dimensions. In that case electrode (410) in FIG. 4 is replaced by a finger of electrodes alongside the conductors (413, 414).

In a second variation, the orientation of the optical polarization filters (400) and (401), is not perpendicular but parallel. In that case the effect of an electrical field between electrodes on translucency is reversed: the absence of an electrical field now corresponds with low translucency, whereas an electrical field increases the translucency.

In a third variation the thin film field effect transistors (412) are not placed along the electrodes (411) (as in FIG. 6A), but rather in or near the middle of them (as in FIG. 6B). Near the middle means within less than 20% of the size of the electrode (411) from its center. At first it may appear that this creates an undesirable black spot in the middle of the pixel. The inventors, however, have found that this effect is beneficial when the panel is used in the context of using the panel for making a relief printing plate, as it provides a structured pattern in the relief printing plate that improves its ink accepting properties and increases the density of solids

### Industrial applicability

The invention is advantageously used for replacing a conventional mask film in a light box for preparing a print master. The print master can be flexographic print master, but also a traditional offset printing plate. The invented system eliminates separate equipment and process steps to create the conventional film mask.

It also eliminates the chemical waste that the creation of a conventional mask film involves as well the waste caused by the mask film itself. Because the invented system involves no moving parts, it is reliable. It can be economically manufactured using standard industrial process that are already available for the manufacturing of LCD displays.

## Claims

1. A method of exposing a print master precursor by an UV light source through a digital mask panel
- wherein the digital mask panel comprising a two-dimensional array of pixels of which the transparency can be individually switched between a first level and a second level that is lower than the first level, the ratio of the first over the second level defining a contrast ratio which exceeds 20/1 in the UV-A part of the electromagnetic spectrum (315-400 nm); and
- whereby the two-dimensional array of pixels additionally comprises:
- a first linear optical polarizing filter (400) having a first orientation; and
- a second linear optical polarizing filter (401) having a second orientation;
- in between said two linear optical polarizing filters (400, 401) liquid crystals (407) having an optical polarization characteristic that can be altered by an electrical field;
- a set of electrodes (410, 411) for each pixel of the array set up to control an electric field within each pixel of the array;
- means (412, 413, 414) for controlling the electric field between the electrodes (410, 411).
wherein, in the plane (X-Y) of the two-dimensional array of pixels, the digital mask panel has a width in the range from 850 mm to 1050 mm and a height in the range from 1150 mm to 1350 mm, and the pixels are squares of size 40 µm x 40 µm or less.

2. A method according to claim 1 whereby said means for controlling (412, 413, 414) comprises a transistor (412).

3. A method according to claim 2 whereby said transistor (412) is located near the middle of an electrode (411) of a pixel of the array, which means within less than 20% of the size of the electrode (411) from its centre.

4. A method according to any of the claims 1 to 3 comprising the step of unpacking by a demultiplexer a stream of incoming bytes into a two-dimensional matrix with digital count values for the pixels; whereby the stream of incoming bytes is a raster bitmap, which is page converted by a raster image processor and wherein the page is described in a page description language.

5. A method of creating an offset print master comprising the method according to any of the claims 1 to 4.

6. A method of creating a flexographic print master comprising the method according to any of the claims 1 to 4.

7. A method according to any of the claims 5 to 6 whereby the digital mask panel further comprises a two-dimensional collimating micro-lens system (420).

8. A method according to any of the claims 5 to 7 whereby the digital-mask panel receives an amount of energy in the UV-A light spectrum from the UV light source, during a single exposure, equivalent to between 9 J/cm² and 18 J/cm² from the UV-light source.

9. A method according to any of the claims 5 to 8 whereby the contrast ratio which exceeds 100/1 in the UV-A part of the electromagnetic spectrum.

10. A method according to any of the claims 5 to 9 whereby a tonal resolution of the digital-mask panel is one bit monochrome.

11. *A* method according to any of the claims 5 to 9 whereby a tonal resolution of the digital-mask panel is two bits or three bits.

12. A method according to any of the claims 10 to 11 whereby a display refresh time of the digital-mask panel is less than 20 seconds.

13. A method according to any of the claims 10 to 11 whereby the display refresh time of the digital-mask panel is less than 5 seconds.

14. A method according to any of the claims 10 to 11 whereby all array pixels from the array of pixels are a square and their size is or is less than 20 µm by 20 µm.

## Patentansprüche

1. Ein Verfahren zur Belichtung einer Druckmastervorstufe mittels einer UV-Lichtquelle durch ein Digitalmaskenpanel,
- wobei das Digitalmaskenpanel eine zweidimensionale Matrix von Pixeln umfasst, deren Transparenz sich individuell zwischen einem ersten Wert und einem zweiten, unter dem ersten Wert liegenden Wert einstellen lässt, wobei das Verhältnis vom ersten Wert zum zweiten Wert ein Kontrastverhältnis, das über 20/1 im UV-A-Teil des elektromagnetischen Spektrums (315-400 nm) liegt, definiert, und
- wobei die zweidimensionale Matrix von Pixeln zusätzlich Folgendes umfasst:
- einen ersten linearen optischen Polarisationsfilter (400) mit einer ersten Orientierung, und
- einen zweiten linearen optischen Polarisationsfilter (401) mit einer zweiten Orientierung,
- zwischen beiden linearen optischen Polarisationsfiltern (400, 401) Flüssigkristalle (407) mit einer optischen Polarisationskennlinie, die sich mittels eines elektrischen Feldes ändern lässt,
- einen Satz von Elektroden (410, 411) für jedes Pixel der Matrix, der so konfiguriert ist, dass er ein elektrisches Feld innerhalb jedes Pixels der Matrix steuert,
- Mittel (412, 413, 414) zur Steuerung des elektrischen Feldes zwischen den Elektroden (410, 411),
wobei in der Ebene (X-Y) der zweidimensionalen Matrix von Pixeln das Digitalmaskenpanel eine Breite im Bereich von 850 nm bis 1050 nm und eine Höhe im Bereich von 1150 nm bis 1350 nm aufweist und die Pixel Quadrate mit einer Größe von höchstens 40 µm x 40 µm sind.

2. Ein Verfahren nach Anspruch 1, wobei das Steuermittel (412, 413, 414) einen Transistor (412) umfasst.

3. Ein Verfahren nach Anspruch 2, wobei sich der Transistor (412) nahe an der Mitte einer Elektrode (411) eines Pixels der Matrix befindet, d.h. innerhalb weniger als 20% der Größe der Elektrode (411) von deren Mitte.

4. Ein Verfahren nach einem der Ansprüche 1 bis 3, umfassend den Schritt, in dem mittels eines Demultiplexers ein Strom eingehender Bytes in eine zweidimensionale Matrix mit digitalen Zählwerten für die Pixel entpackt wird, wobei der Strom eingehender Bytes ein Rasterbitmap ist, in den eine Seite durch einen Rasterbildprozessor konvertiert wird, und wobei die Seite in einer Seitenbeschreibungssprache beschrieben wird.

5. Ein Verfahren zur Herstellung eines Offsetdruckmasters, das das Verfahren nach einem der Ansprüche 1 bis 4 umfasst.

6. Ein Verfahren zur Herstellung eines flexografischen Druckmasters, das das Verfahren nach einem der Ansprüche 1 bis 4 umfasst.

7. Ein Verfahren nach einem der Ansprüche 5 bis 6, wobei das Digitalmaskenpanel ferner ein zweidimensionales Kollimatormikrolinsensystem (420) umfasst.

8. Ein Verfahren nach einem der Ansprüche 5 bis 7, wobei das Digitalmaskenpanel während einer einzelnen Belichtung von der UV-Lichtquelle eine Menge Energie im UV-A-Lichtspektrum, die einem Wert zwischen 9 J/cm² und 18 J/cm² von der UV-Lichtquelle entspricht, empfängt.

9. Ein Verfahren nach einem der Ansprüche 5 bis 8, wobei das Kontrastverhältnis über 100/1 im UV-A-Teil des elektromagnetischen Spektrums liegt.

10. Ein Verfahren nach einem der Ansprüche 5 bis 9, wobei eine Tonauflösung des Digitalmaskenpanels 1-Bit-monochrom ist.

11. Ein Verfahren nach einem der Ansprüche 5 bis 9, wobei eine Tonauflösung des Digitalmaskenpanels 2-Bit oder 3-Bit ist.

12. Ein Verfahren nach einem der Ansprüche 10 bis 11, wobei eine Aktualisierungszeit der Anzeige des Digitalmaskenpanels bei weniger als 20 Sekunden liegt.

13. Ein Verfahren nach einem der Ansprüche 10 bis 11, wobei die Aktualisierungszeit der Anzeige des Digitalmaskenpanels bei weniger als 5 Sekunden liegt.

14. Ein Verfahren nach einem der Ansprüche 10 bis 11, wobei alle Matrixpixel der Pixelmatrix ein Quadrat sind und ihre Größe bei höchstens 20 *µ*m x 20 *µ*m liegt.

## Revendications

1. Procédé pour l'exposition d'un précurseur de matrice d'impression à l'aide d'une source de lumière ultraviolette à travers un panneau de masque numérique,
- ledit panneau de masque numérique comprenant une matrice de pixels bidimensionnelle dont la transparence se laisse régler entre un premier niveau et un deuxième niveau qui est inférieur audit premier niveau, le rapport du premier niveau au deuxième niveau définissant un rapport de contraste qui est supérieur à 20/1 dans la région UV-A du spectre électromagnétique (315-400 nm), et
- ladite matrice de pixels bidimensionnelle comprenant en outre:
- un premier filtre de polarisation linéaire optique (400) ayant une première orientation, et
- un deuxième filtre de polarisation linéaire optique (401) ayant une deuxième orientation,
- entre les deux filtres de polarisation linéaires optiques (400, 401) des cristaux liquides (407) ayant une caractéristique de polarisation optique qui se laisse modifier à l'aide d'un champ électrique,
- un ensemble d'électrodes (410, 411) pour chaque pixel de la matrice, ledit ensemble étant configuré de façon à contrôler un champ électrique dans chaque pixel de la matrice,
- des moyens (412, 413, 414) servant à contrôler le champ électrique entre les électrodes (410, 411),
**caractérisé en ce que**, dans le plan (X-Y) de la matrice de pixels bidimensionnelle, le panneau de masque numérique présente une largeur comprise dans l'intervalle de 850 nm à 1050 nm et une hauteur comprise dans l'intervalle de 1150 nm à 1350 nm et que les pixels sont des carrés ayant des dimensions maximales de 40 µm x 40 *µ*m.

2. Procédé selon la revendication 1, **caractérisé en ce que** le moyen de contrôle (412, 413, 414) comprend un transistor (412).

3. Procédé selon la revendication 2, **caractérisé en ce que** le transistor (412) se situe près du centre d'une électrode (411) d'un pixel de la matrice, c'est-à-dire à une distance par rapport audit centre qui est inférieure à 20% des dimensions de l'électrode (411).

4. Procédé selon l'une quelconque des revendications 1 à 3, comprenant l'étape consistant à décompresser, à l'aide d'un démultiplexeur, un flux de bits d'entrée en une matrice bidimensionnelle ayant des valeurs de comptage numériques pour les pixels, ledit flux de bits d'entrée étant un bitmap tramé dans lequel est convertie une page à l'aide d'un processeur d'image tramée et ladite page étant décrite dans un langage de description de page.

5. Procédé pour la fabrication d'une matrice d'impression offset comprenant le procédé selon l'une quelconque des revendications 1 à 4.

6. Procédé pour la fabrication d'une matrice d'impression flexographique comprenant le procédé selon l'une quelconque des revendications 1 à 4.

7. Procédé selon l'une quelconque des revendications 5 à 6, **caractérisé en ce que** le panneau de masque numérique comprend en outre un système de microlentilles collimatrices bidimensionnel (420).

8. Procédé selon l'une quelconque des revendications 5 à 7, **caractérisé en ce que**, lors d'une seule exposition, le panneau de masque numérique reçoit de la source de lumière ultraviolette une quantité d'énergie dans le spectre de lumière UV-A qui est équivalente à une valeur comprise entre 9 J/cm² et 18 J/cm² de la source de lumière ultraviolette.

9. Procédé selon l'une quelconque des revendications 5 à 8, **caractérisé en ce que** le rapport de contraste est supérieur à 100/1 dans la région UV-A du spectre électromagnétique.

10. Procédé selon l'une quelconque des revendications 5 à 9, **caractérisé en ce qu'**une résolution tonale du panneau de masque numérique est monochrome 1 bit.

11. Procédé selon l'une quelconque des revendications 5 à 9, **caractérisé en ce qu'**une résolution tonale du panneau de masque numérique est 2 bits ou 3 bits.

12. Procédé selon l'une quelconque des revendications 10 à 11, **caractérisé en ce qu'**un temps de rafraîchissement de l'afficheur du panneau de masque numérique est inférieur à 20 secondes.

13. Procédé selon l'une quelconque des revendications 10 à 11, **caractérisé en ce que** le temps de rafraîchissement de l'afficheur du panneau de masque numérique est inférieur à 5 secondes.

14. Procédé selon l'une quelconque des revendications 10 à 11, **caractérisé en ce que** tous les pixels de matrice de la matrice de pixels sont des carrés et que leurs dimensions maximales sont de 20 *µ*m x 20 *µ*m.
